# EUROPÄISCHE PATENTSCHRIFT

(11) **EP 1 920 473 B1**
(45) Veröffentlichungstag und Bekanntmachung des Hinweises auf die Patenterteilung: **26.11.2008**
(21) Anmeldenummer: 06849396.4
(22) Anmeldetag: 03.08.2006
(51) Int. Cl.: H01L 41/047, H01L 41/083

(54) **PIEZOAKTOR MIT INNENLIEGENDER KONTAKTIERUNG**
PIEZOELECTRIC ACTUATOR WITH INTERNAL CONTACT-CONNECTION
PIÉZOACTIONNEUR DOTÉ DE CONTACTS INTÉRIEURS

(30) Priorität: 25.08.2005 DE 102005040122
(43) Veröffentlichungstag der Anmeldung: 14.05.2008
(73) Patentinhaber: Robert Bosch GmbH, 70442 Stuttgart (DE)
(72) Erfinder: HEINZ, Rudolf, 71272 Renningen (DE)
(86) Internationale Anmeldenummer: PCT/EP2006/065005
(87) Internationale Veröffentlichungsnummer: WO 2007/112786

(56) Entgegenhaltungen:
- WO-A-03/094252
- DE-A1- 10 335 019
- DE-A1-0102005 033 40

## Beschreibung

### Technisches Gebiet

Die Erfindung betrifft einen Piezoaktor mit innenliegender Kontaktierung, beispielsweise als Bestandteil eines Piezoinjektors bzw. zur Betätigung eines mechanischen Bauteils wie ein Ventil oder dergleichen, nach den gattungsgemäßen Merkmalen des Hauptanspruchs.

### Stand der Technik

Es ist an sich bekannt, dass zum Aufbau des zuvor erwähnten Piezoaktors ein Piezoelement so eingesetzt werden kann, dass unter Ausnutzung des sogenannten Piezoeffekts eine Steuerung des Nadelhubes eines Ventils oder dergleichen vorgenommen werden kann, wobei das Piezoelement aus einem Material mit einer geeigneten Kristallstruktur aufgebaut ist. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Der Aufbau eines solchen Piezoaktors erfolgt beim Stand der Technik in mehreren Schichten als sogenannter Multilayer-Aktor, wobei Innenelektroden, über die die elektrische Spannung aufgebracht wird, jeweils in Wirkrichtung zwischen den Schichten angeordnet werden und jeweils außen oder innen kontaktiert werden.

Aus der DE 103 35 019 A1 ist ein solcher Piezoaktor bekannt, der ein Piezoelement mit einem Mehrschichtaufbau von Piezolagen und mit in Wirkrichtung dazwischen angeordneten Innenelektroden aufweist, die alternierend mit einer positiven und einer negativen elektrischen Ladung beaufschlagbar sind. Die wechselseitige Kontaktierung der Innenelektroden mit Kontaktelementen erfolgt hier derart, dass diese Kontaktelemente jeweils in einer inneren Ausnehmung des Piezoelements liegen und dann mit den jeweiligen Innenelektroden in geeigneter Weise kontaktiert werden. Zum Beispiel kann dies durch ein entsprechendes Design der jeweiligen Innenelektroden erfolgen, die abhängig von der jeweiligen Polarität jeweils ein unterschiedliches Designmuster aufweisen, und dabei wechselseitig an die inneren Ausnehmungen herangeführt werden.

Zur äußeren Kontaktierung werden die innenliegenden Stifte dabei senkrecht zum Lagenaufbau nach außen geführt. Beim Piezoaktor nach dem Stand der Technik sind die Kontaktelemente dabei elektrisch leitende Stifte, die mit einem leitfähigen Stoff, z.B. ein Polymer, derart vergossen sind, dass die jeweilige Kontaktierung der Innenelektroden mit dem positiven und dem negativen Anschluss einer Spannungsquelle über die jeweils zugeordneten Stifte durchführbar ist.

Der leitfähige Stoff sollte dabei so beschaffen sein, dass er im vorgegebenen Bauraum die durch den Hub des Piezoelements und durch Temperaturwechsel entstehende Dehnung aufnehmen kann und dabei sicherstellt, dass die elektrische Kontaktierung der Innenelektroden über die Lebensdauer des Piezoaktors gegeben ist.

### Offenbarung der Erfindung

Der eingangs beschriebene Piezoaktor mit einem Mehrschichtaufbau von Piezolagen eines Piezoelements und mit in Wirkrichtung dazwischen angeordneten Innenelektroden, die alternierend mit einer positiven und einer negativen elektrischen Ladung beaufschlagbar sind, weist eine innere wechselseitige Kontaktierung der Innenelektroden auf. Erfindungsgemäß ist in vorteilhafter Weise dabei die innere Kontaktierung so aufgebaut, dass die Kernelektroden mit einem vor der Montage aufbringbaren leitfähigen Elastomer als Ummantelung versehen sind, die eine vorgegebene Kerbgeometrie zur Erhöhung der Elastizität aufweist. Bevorzugt besteht dabei die Kerbgeometrie aus einer wendelförmig in Längsrichtung um die Ummantelung geführten Einkerbung.

Im allgemeinen ist die innenliegende elektrische Anbindung der Innenelektroden insbesondere bei der Verwendung als Piezoaktor in Einspritzsystemen für Kraftstoff, zum Beispiel Diesel, bei einem Kraftfahrzeug vorteilhaft, da hier eine bessere Hochdruckabdichtung gegen den außen am Piezoaktor anliegenden Kraftstoffdruck ermöglicht wird.

Der erfindungsgemäße Vorschlag mit der Einbringung von elastomerbeschichteten Kernelektroden ist vor allem deswegen vorteilhaft, da ansonsten die Anbringung der innenliegenden Kontaktelemente in die relativ kleinen und langen Bohrungen als Ausnehmungen, mit ca. 1 mm Durchmesser bei einer Länge von 50 mm bis 70 mm, recht schwierig ist. Mit den vorgeschlagenen wendelförmig geführten Einkerbungen ist auch eine leichte Montage der Kontaktelemente erreichbar, da sich hiermit quasi eine Einschraubung der Kontaktelemente durchführen lässt.

Das beim Stand der Technik notwendige nachträgliche Befülllen der Bohrungen entfällt damit auch. Außerdem sind die fertigen Kontaktelemente als Anschlusselektroden nach der Erfindung bereits außerhalb des Piezoaktors vor dem Einbringen in die Bohrungen elektrisch und mechanisch prüfbar.

Die vorgeschlagenen erfindungsgemäßen Ausführungsformen sind durch die Kerbgeometrie in vorteilhafter Weise mit einer optimalen Elastizität versehen, wobei sich, wie oben erwähnt, die Kerbgeometrie bevorzugt wendelförmig über die ganze Länge der Kontaktelemente erstreckt und damit über die Lebensdauer des Piezoaktors mit starken Hubwechsel des Piezoelements einen ausreichender Anpressdruck an die Bohrung und eine gute Kontaktierung der Innenelektroden ermöglicht. Es erfolgt somit auch kein statischer Druckaufbau am Kontaktelement. Vorteilhaft ist hier außerdem, wenn die Kerbgeometrie zur weiteren Verbesserung der Elastizität zusätzlich noch mindesten einen Längsschlitz aufweist.

Bei einer ersten Ausführungsform sind die Kernelektroden als Stifte mit konstantem Umfang ausgeführt. Gemäß einer zweiten Ausführungsform sind die Kernelektroden mit einem kegelförmig sich zum Kopfteil des Piezoaktors hin sich verjüngenden Querschnitt ausgeführt, wodurch die Elastizität besonders im hubaktiven Kopfteil durch die stärkere Ummantelung verbessert ist. Nach einer dritten Ausführungsform sind die Kernelektroden spiralförmig ausgeführt, wodurch auch die in der Regel metallischen Kernelektroden einen gewissen mechanischen Hub mitmachen können.

Weitere Ausführungsformen betreffen Kernelektroden, die als Stifte mit konstantem Umfang ausgeführt sind, wobei jedoch die Bohrungen zur Aufnahme der Kontaktelemente mit einem kegelförmig sich zum Kopfteil des Piezoaktors hin sich verjüngenden oder verbreiternden Querschnitt ausgeführt sind. Hierbei werden die Kontaktelemente jeweils von der Seite mit dem breiteren Querschnitt eingebracht, wodurch sich sowohl eine bessere Montierbarkeit als auch Demontierbarkeit für die Kontaktelemente ergibt.

Bei der Montage der zuletzt genannten Ausführungsformen ist der Anpressdruck des Elastomers an der Innenwand der Bohrungen zur Aufnahme der Kontaktelemente durch die Montagekraft leicht steuerbar. Hierbei kann auch ein Unterkühlen der Kernelektrode hilfreich sein. In jedem Fall ist auch die Demontage zur Kegelöffnung hin leicht zu bewerkstelligen.

### Kurze Beschreibung der Zeichnungen

Ausführungsbeispiele des erfindungsgemäßen Piezoaktors werden anhand der Zeichnungen erläutert. Es zeigen:
Figur 1 einen Längsschnitt durch einen Piezoaktor nach dem Stand der Technik mit innenliegender Kontaktierung der Innenelektroden,
Figur 2a einen Teillängsschnitt und Figur 2b einen Querschnitt durch ein erfindungsgemäßes Ausführungsbeispiel eines Piezoaktors mit innenliegender Kontaktierung, bei der eine Kernelektrode mit einem leitfähigen Elastomer mit einer ersten Geometrie versehen ist,
Figur 3a einen Teillängsschnitt und Figur 3b einen Querschnitt durch ein erfindungsgemäßes Ausführungsbeispiel eines Piezoaktors mit innenliegender Kontaktierung, bei der eine Kernelektrode mit einem leitfähigen Elastomer mit einer zweiten Geometrie versehen ist,
Figur 4 einen Teillängsschnitt durch ein erfindungsgemäßes Ausführungsbeispiel eines Piezoaktors mit innenliegender Kontaktierung, bei der eine kegelförmige Kernelektrode mit einem leitfähigen Elastomer versehen ist,
Figur 5 einen Teillängsschnitt durch ein erfindungsgemäßes Ausführungsbeispiel eines Piezoaktors mit innenliegender Kontaktierung, bei der eine spiralförmige Kernelektrode mit einem leitfähigen Elastomer versehen ist,
Figur 6 einen Teillängsschnitt durch ein erfindungsgemäßes Ausführungsbeispiel eines Piezoaktors mit innenliegender Kontaktierung, bei der eine oben weite kegelförmige Bohrung für die Kernelektrode vorhanden ist und
Figur 7 einen Teillängsschnitt durch ein erfindungsgemäßes Ausführungsbeispiel eines Piezoaktors mit innenliegender Kontaktierung, bei der eine oben engere kegelförmige Bohrung für die Kernelektrode vorhanden ist.

### Ausführungsform(en) der Erfindung

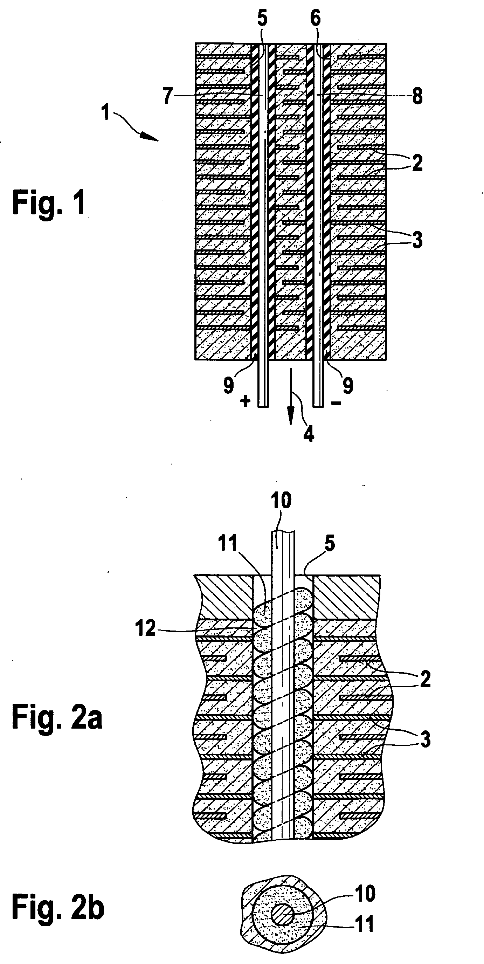

In Figur 1 ist ein Piezoelement gezeigt, das der wesentliche Bestandteil eines als sogenannter Multilayer aufgebauten Piezoaktors 1 nach dem Stand der Technik DE 103 35 019 A1 ist, wobei das Piezoelement aus Piezofolien eines Quarzmaterials mit einer geeigneten Kristallstruktur aufgebaut ist, so dass unter Ausnutzung des sogenannten Piezoeffekts, bei Anlage einer äußeren elektrischen Spannung an hier nur beispielhaft mit Bezugszeichen versehene Innenelektroden 2 und 3, eine mechanische Reaktion des Piezoaktors 1 in Wirkrichtung 4 erfolgt. Im Inneren des Piezoaktors 1 befinden sich zwei in Längsrichtung erstreckte Ausnehmungen bzw. Bohrungen 5 und 6, wobei die Innenelektroden 2 und 3 mit einem entsprechenden Oberflächendesign je nach Polarität an die linke Bohrung 5 oder an die rechte Bohrung 6 herangeführt sind.

In den Bohrungen 5 und 6 sind Kontaktelemente, hier runde Stifte als Kernelektrode 7 und 8 vorhanden, die in einem leitfähigen aber flexiblen Stoff 9, z.B. ein Polymer, durch Vergießen fest eingebettet sind. Die Kernelektroden 7 und 8 und der leitfähige Stoff 9 kontaktieren die Innenelektroden nach außen, so dass mit der Anlage einer elektrischen Spannung an Kontaktbereiche (in der Figur 1 unten angeordnet) der Kernelektroden 7 und 8 die zuvor beschriebene Wirkung hervorgerufen werden kann. Eine Anbringung der in der Regel metallischen Kernelektroden 7 und 8 ist beim Stand der Technik ebenso wie bei den erfindungsgemäßen Ausführungen notwendig, da die elektrische Leitfähigkeit nur des flexiblen Stoffes in der Regel nicht groß genug ist um den Gesamtstrom zur Ansteuerung der Innenelektroden 2 und 3 zu leiten.

Aus Figur 2a und 2b ist jeweils beispielhaft als Teillängsschnitt und als Querschnitt eine erfindungsgemäße Anordnung mit einer metallischen Kernelektrode 10 zu entnehmen, die bereits vor dem Einfügen in die Bohrung 5 mit einer elektrisch leitfähigen Ummantelung 11, zum Beispiel einem elastischen Leitkleber oder ein Elastomer, versehen ist. Die Ummantelung 11 ist bei diesem Ausführungsbeispiel mit einer Kerbgeometrie in Form einer wendelförmig angebrachten Einkerbung 12 versehen. Durch die wendelförmig über den ganzen Bereich der Ummantelung 11 angebrachte Einkerbung 12 ist ein vereinfachtes Einpassen in die Bohrung 5 ermöglicht und während des Betriebs kann auch bei einer möglichen Wärmedehnung des Materials der Ummantelung 11 eine sichere elektrische Kontaktierung gewährleistet werden.

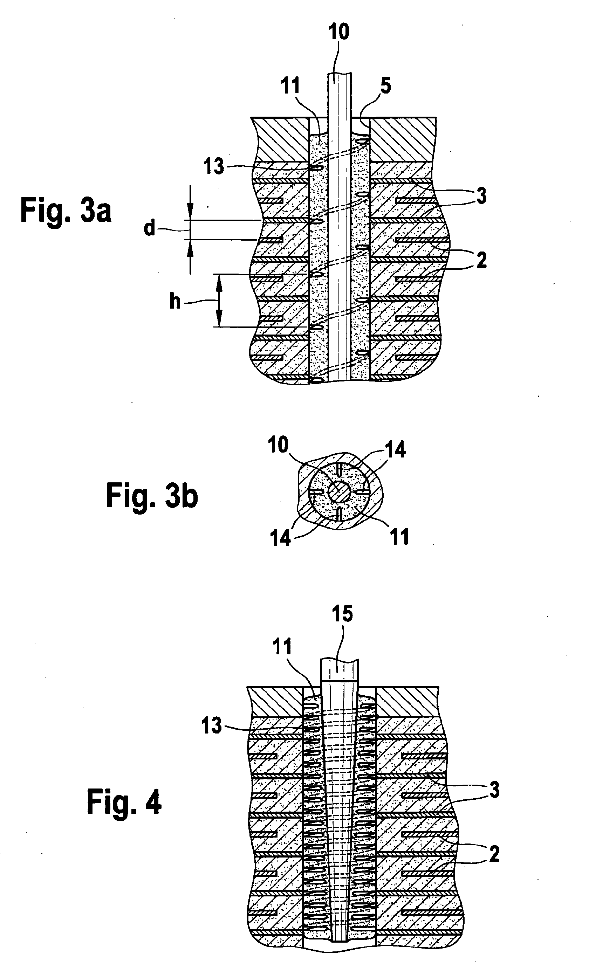

Aus Figur 3a und 3b ist beispielhaft als Teillängsschnitt und als Querschnitt eine Abwandlung der Anordnung nach den Figuren 2a und 2b zu entnehmen, bei der eine abweichende Geometrie einer wendelförmigen Einkerbung 13 vorhanden ist, bei der die Einkerbungsabstände und somit die Steigung h nicht kleiner, zum Beispiel h ≈2d....6d, gegenüber dem Abstand der Innenelektroden 2 und 3 gewählt werden sollen, damit bei einer Einkerbungsbreite s von ca. 1xd eine Kontaktlücke von nicht mehr als ca. 90° zur Innenelektrode entsteht. Hiermit kann die Innenelektrodenkontaktierung möglichst elastisch auf den Hub des Piezoaktors 1 reagieren und ein Schlupf zwischen der Ummantelung 11 und der Bohrung 5 ist zumindest vermindert.

Die Querschnittdarstellung nach der Figur 3b zeigt als Erweiterung die Möglichkeit Längsschlitze 14 anzubringen, mit denen die Elastizität bei diesem Ausführungsbeispiel noch verbessert werden kann.

Figur 4 zeigt ein Ausführungsbeispiel mit einer kegelförmigen Kernelektrode 15 die in einer mit der Figur 3a vergleichbaren Weise eine Ummantelung 11 mit der wendelförmigen Einkerbung 13 aufweist. Bei der Kernelektrode 15 nach der Figur 4 befindet sich der Bereich mit dem größeren Umfang am Fuß des Piezoaktors 1 und der Bereich mit dem geringeren Umfang befindet sich im Kopfbereich des Piezoaktors 1. Damit ist erreicht, dass im Kopfbereich, der den größten Hub des Piezoaktors 1 aufweist, beispielsweise 70 bis 100 µm, die Ummantelung 11 den größten Bereich ausfüllt und damit dieser Bereich eine große Elastizität besitzt.

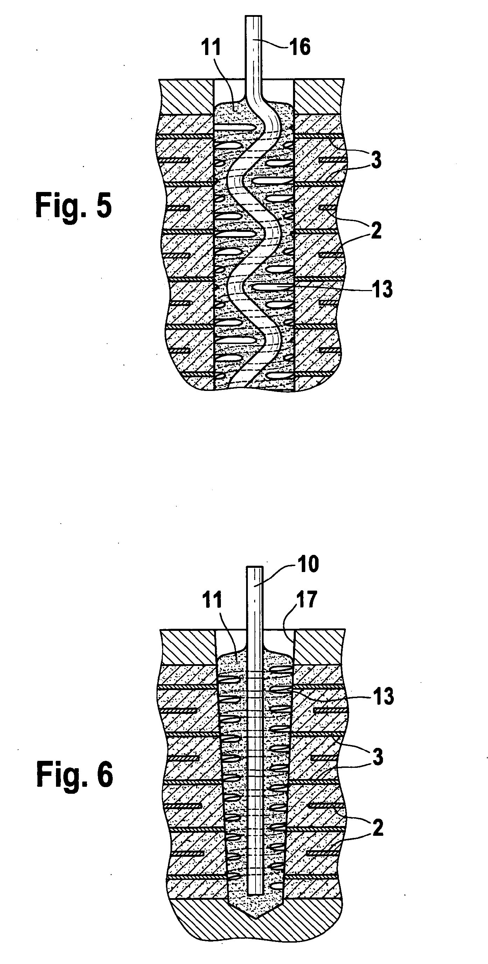

In Figur 5 ist ein Ausführungsbeispiel mit einer spiralförmigen Kernelektrode 16 gezeigt, die ebenfalls in einer mit der Figur 3a vergleichbaren Weise eine Ummantelung 11 mit der wendelförmigen Einkerbung 13 aufweist. Bei der spiralförmigen Kernelektrode 16 nach der Figur 5 kann diese den Hub des Piezoaktors 1 zumindest teilweise mitmachen, wodurch eine geringere Hubbewegung auf die Ummantelung 11 entfällt.

Aus Figur 6 ist ein Ausführungsbeispiel mit einer stiftförmigen Kernelektrode 10 zu entnehmen, die ebenfalls in einer mit der Figur 3a vergleichbaren Weise eine Ummantelung 11 mit der wendelförmigen Einkerbung 13 aufweist. Bei diesem Ausführungsbeispiel ist eine Bohrung 17 mit einem vom Fuß- zum Kopfteil des Piezoaktors 1 kegelförmig spitz zulaufenden Querschnitt vorhanden. Hierbei kann die Anpresskraft in der Bohrung 17 bei der Montage gesteigert werden und es ist eine leichte Demontierbarkeit der Innelektrodenkontaktierung erreichbar.

Beim Ausführungsbeispiel nach der Figur 6 kann zur Verbesserung des elektrischen Kontakts in der Bohrung 17 vor der Montage noch die Oberfläche der Bohrung 17 mit einem leitfähigen Kleber fast ohne Verschmieren versehen werden.

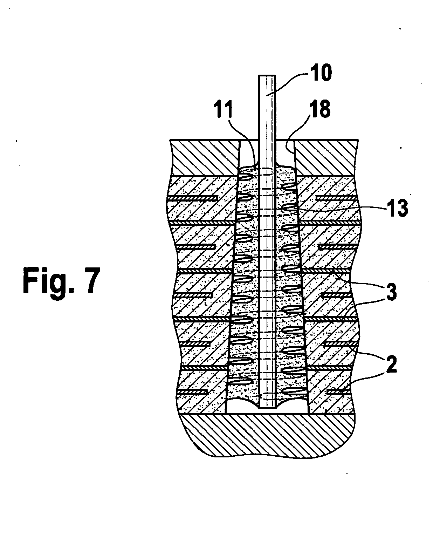

Ein Ausführungsbeispiel nach Figur 7 zeigt eine stiftförmige Kernelektrode 10, die ebenfalls in einer mit der Figur 3a vergleichbaren Weise eine Ummantelung 11 mit der wendelförmigen Einkerbung 13 aufweist. Bei diesem Ausführungsbeispiel ist eine Bohrung 18 mit einem vom oberen Fußteil zum Kopfteil des Piezoaktors 1 kegelförmig sich vergrößernden Querschnitt vorhanden.

Die Montage erfolgt beim Ausführungsbeispiel nach der Figur 7 von unten, dass heißt vom Kopfteil, so dass auch hier die Anpresskraft in der Bohrung 18 bei der Montage gesteigert werden kann. Bei diesem Ausführungsbeispiel liegt somit die größte Elastizität der Ummantelung 11 im Kopfbereich, in dem der Piezoaktor 1 den größten Hub macht.

### Gewerbliche Anwendbarkeit

Die Erfindung ist bei Einspritzsystemen für Kraftstoff, zum Beispiel Diesel, in einem Kraftfahrzeug mit einem Verbrennungsmotor gewerblich anwendbar.

## Patentansprüche

1. Piezoaktor, mit
- einem Piezoelement, bestehend aus einem Mehrschichtaufbau von Piezolagen mit in Wirkrichtung dazwischen angeordneten Innenelektroden (2,3), die alternierend mit einer positiven und einer negativen elektrischen Ladung beaufschlagbar sind, und mit
- einer wechselseitigen Kontaktierung der Innenelektroden (2,3), die mit Kontaktelementen, bestehend aus jeweils einer Kernelektrode (10;15;16) und einer elektrisch leitfähigen elastischen Ummantelung (9;11), erfolgt, die in inneren Ausnehmungen (5,6;17,18) des Piezoelements liegen und dabei senkrecht zum Lagenaufbau nach außen geführt sind,
**dadurch gekennzeichnet, dass**
- die Kernelektroden (10;15;16) mit einem vor der Montage aufbringbaren leitfähigen Elastomer (11) als Ummantelung versehen sind, das eine vorgegebene Kerbgeometrie (12;13) zur Erhöhung der Elastizität aufweist.

2. Piezoaktor nach Anspruch 1, **dadurch gekennzeichnet, dass**
- die Kerbgeometrie aus einer wendelförmig in Längsrichtung um die Ummantelung (11) geführten Einkerbung (12;13) besteht.

3. Piezoaktor nach Anspruch 2, **dadurch gekennzeichnet, dass**
- die Steigung (h) der wendelförmigen Einkerbung (13) in Abhängigkeit von der Einkerbungsbreite (s) und gegenüber dem Abstand (d) der Innenelektroden (2,3) so eingestellt ist, dass eine Kontaktlücke von ca. 90° nicht überschritten ist.

4. Piezoaktor nach einem der vorhergehenden Ansprüche, **dadurch gekennzeichnet, dass**
- die Kerbgeometrie (13) zusätzlich mindestens einen Längsschlitz (14) aufweist.

5. Piezoaktor nach einem der vorhergehenden Ansprüche, **dadurch gekennzeichnet, dass**
- die Kernelektroden (10) als Stifte mit konstantem Umfang ausgeführt sind.

6. Piezoaktor nach einem der Ansprüche 1 bis 4, **dadurch gekennzeichnet, dass**
- die Kernelektroden (15) mit einem kegelförmig sich zum Kopfteil des Piezoaktors (1) hin sich verjüngenden Querschnitt ausgeführt sind.

7. Piezoaktor nach einem der Ansprüche 1 bis 4, **dadurch gekennzeichnet, dass**
- die Kernelektroden (16) spiralförmig ausgeführt sind.

8. Piezoaktor nach einem der Ansprüche 1 bis 4, **dadurch gekennzeichnet, dass**
- die Kernelektroden (10) als Stifte mit konstantem Umfang ausgeführt sind und dass
- die Bohrungen (17) zur Aufnahme der Kontaktelemente mit einem kegelförmig sich zum Kopfteil des Piezoaktors (1) hin sich verjüngenden Querschnitt ausgeführt sind.

9. Piezoaktor nach einem der Ansprüche 1 bis 4, **dadurch gekennzeichnet, dass**
- die Kernelektroden (10) als Stifte mit konstantem Umfang ausgeführt sind und dass
- die Bohrungen (18) zur Aufnahme der Kontaktelemente mit einem kegelförmig sich zum Fußteil des Piezoaktors (1) hin sich verjüngenden Querschnitt ausgeführt sind.

10. Piezoaktor nach einem der vorhergehenden Ansprüche, **dadurch gekennzeichnet, dass**
- die gesamte Anordnung zur Nadelhubsteuerung für die Kraftstoffeinspritzung in einem Kraftfahrzeug einsetzbar ist.

## Claims

1. Piezoelectric actuator, with
- a piezoelectric element, comprising a multilayer structure of piezoelectric layers with inner electrodes (2, 3) which are arranged in between in the operating direction and can be alternately subjected to a positive and a negative electrical charge, and with
- reciprocal contact of the inner electrodes (2, 3), which takes place with contact elements respectively comprising a core electrode (10; 15; 16) and an electrically conductive elastic sheathing (9; 11), which lie in inner recesses (5, 6; 17, 18) of the piezoelectric element and are thereby led to the outside perpendicularly in relation to the layer structure,
**characterized in that**
- the core electrodes (10; 15; 16) are provided with a conductive elastomer (11), which can be applied as sheathing before assembly and has a predetermined notch geometry (12; 13) to increase the elasticity.

2. Piezoelectric actuator according to Claim 1, **characterized in that**
- the notch geometry comprises a notch (12; 13) led helically around the sheathing (11) in the longitudinal direction.

3. Piezoelectric actuator according to Claim 2, **characterized in that**
- the pitch (h) of the helical notch (13) is set on the basis of the notch width (s) and with respect to the spacing (d) of the inner electrodes (2, 3) in such a way that a contact gap of about 90° is not exceeded.

4. Piezoelectric actuator according to one of the preceding claims, **characterized in that**
- the notch geometry (13) additionally has at least one longitudinal slit (14).

5. Piezoelectric actuator according to one of the preceding claims, **characterized in that**
- the core electrodes (10) are formed as pins with a constant circumference.

6. Piezoelectric actuator according to one of Claims 1 to 4, **characterized in that**
- the core electrodes (15) are formed with a cross section tapering conically towards the head part of the piezoelectric actuator (1).

7. Piezoelectric actuator according to one of Claims 1 to 4, **characterized in that**
- the core electrodes (16) are spirally formed.

8. Piezoelectric actuator according to one of Claims 1 to 4, **characterized in that**
- the core electrodes (10) are formed as pins with a constant circumference and **in that**
- the bores (17) for receiving the contact elements are formed with a cross section tapering conically towards the head part of the piezoelectric actuator (1).

9. Piezoelectric actuator according to one of Claims 1 to 4, **characterized in that**
- the core electrodes (10) are formed as pins with a constant circumference and **in that**
- the bores (18) for receiving the contact elements are formed with a cross section tapering conically towards the foot part of the piezoelectric actuator (1).

10. Piezoelectric actuator according to one of the preceding claims, **characterized in that**
- the overall arrangement can be used for needle stroke control for the fuel injection in a motor vehicle.

## Revendications

1. Actionneur piézo-électrique comprenant :
- un élément piézo-électrique formé par une structure stratifiée de couches piézo-électriques avec des électrodes intérieures (2, 3) installées entre celles-ci dans la direction d'action, ces électrodes intérieures recevant en alternance une charge électrique positive et une charge électrique négative, et
- une mise en contact sur les côtés alternés des électrodes intérieures (2, 3) par des éléments de contact formés respectivement d'une électrode centrale (10 ; 15 ; 16) et d'une gaine élastique électroconductrice (9 ; 11), dans les cavités intérieures (5, 6; 17, 18) de l'élément piézo-électrique et passant vers l'extérieur perpendiculairement à la structure des couches,
**caractérisé en ce que**
les électrodes centrales (10 ; 15 ; 16) sont munies d'un revêtement constitué par un élastomère électroconducteur (11) appliqué avant le montage et présentant une géométrie d'encoches (12 ; 13) prédéfinie pour augmenter l'élasticité.

2. Actionneur piézo-électrique selon la revendication 1,
**caractérisé en ce que**
- la géométrie d'encoches est obtenue par une encoche (12 ; 13) ayant un tracé hélicoïdal dans la direction longitudinale autour de la gaine (11).

3. Actionneur piézo-électrique selon la revendication 1,
**caractérisé en ce que**
- le pas (h) de l'encoche hélicoïdale (13) est réglé en fonction de la largeur (s) de l'encoche et par rapport à la distance (d) des électrodes intérieures (2, 3) pour ne pas dépasser un intervalle de contact d'environ 90°.

4. Actionneur piézo-électrique selon les revendications précédentes,
**caractérisé en ce que**
- la géométrie de l'encoche (13) comporte en outre au moins une fente longitudinale (14).

5. Actionneur piézo-électrique selon les revendications précédentes,
**caractérisé en ce que**
- les électrodes centrales (10) sont des broches à périphérie constante.

6. Actionneur piézo-électrique selon les revendications 1 à 4,
**caractérisé en ce que**
- les électrodes centrales (15) sont réalisées avec une section de forme conique, allant en diminuant vers la partie de tête de l'actionneur piézo-électrique (1).

7. Actionneur piézo-électrique selon les revendications 1 à 4,
**caractérisé en ce que**
- les électrodes centrales (16) sont réalisées avec une forme en spirale.

8. Actionneur piézo-électrique selon les revendications 1 à 4,
**caractérisé en ce que**
- les électrodes centrales (10) sont réalisées sous la forme de broches ayant une périphérie constante, et
- les perçages (17) recevant les éléments de contact sont réalisés suivant une forme conique de section allant en diminuant vers la partie de tête de l'actionneur piézo-électrique (1).

9. Actionneur piézo-électrique selon les revendications 1 à 4,
**caractérisé en ce que**
- les électrodes centrales (10) sont réalisées sous la forme de broches ayant une périphérie constante, et
- les perçages (18) recevant les éléments de contact sont réalisés suivant une forme conique de section allant en diminuant vers la partie de base de l'actionneur piézo-électrique (1).

10. Actionneur piézo-électrique selon les revendications précédentes,
**caractérisé en ce que**
- la disposition globale est utilisée pour commander la course de l'aiguille d'injecteur pour l'injection de carburant dans un véhicule automobile.
